# EUROPÄISCHE PATENTSCHRIFT

(11) **EP 0 507 181 B1**
(45) Veröffentlichungstag und Bekanntmachung des Hinweises auf die Patenterteilung: **03.06.1998**
(21) Anmeldenummer: 92104987.0
(22) Anmeldetag: 23.03.1992
(51) Int. Cl.: G03F 3/10, G03F 7/34

(54) **Verfahren zur Herstellung eines Mehrfarben-Prüfbildes und hierfür geeignetes strahlungsempfindliches Aufzeichnungsmaterial**
Process for the fabrication of colour-proofs and light sensitive material therefor
Procédé pour la fabrication d'épreuves en couleur et matériel photosensible à cet effet

(30) Priorität: 27.03.1991 DE 4110057
(43) Veröffentlichungstag der Anmeldung: 07.10.1992
(73) Patentinhaber: Agfa-Gevaert AG, 51373 Leverkusen (DE)
(72) Erfinder: Mohr, Dieter, Dr., W-6501 Budenheim (DE); Zertani, Rudolf, Dr., W-6500 Mainz 43 (DE); Mertes, Jürgen, Dr., W-6507 Ingelheim (DE); Benzing, Martin, Dr., W-6501 Mommenheim (DE)
(74) Vertreter: Zounek, Nikolai, Dipl.-Ing.

(56) Entgegenhaltungen:
- EP-A- 0 169 049
- EP-A- 0 362 827
- EP-A- 0 411 839
- FR-A- 2 374 664
- GB-A- 2 096 781

## Beschreibung

Die vorliegende Erfindung betrifft ein Verfahren zur Herstellung eines Mehrfarben-Prüfbildes für die graphische Industrie und ein hierfür geeignetes strahlungsempfindliches Aufzeichnungsmaterial, das aus einem üblicherweise flächigen temporären Schichtträger, einer Farbmittel enthaltenden, thermisch übertragbaren Schicht und einer darüber angeordneten strahlungsempfindlichen Schicht besteht.

Im Mehrfarbendruck wird im allgemeinen eine Farbprüfung vorgenommen, um die Korrektur der für die Belichtung von Druckplatten verwendeten Farbauszüge zu ermöglichen. Das Prüfbild muß ein getreues Abbild des gewünschten Raster- oder Strichbildes sein und soll den Tonwert der Farben weder erhöht noch herabgesetzt wiedergeben. Die visuelle Farbprüfung soll Fehler in der Vorlage anzeigen, die beste Farbwiedergabe, die beim Drucken in der Maschine zu erwarten ist, ermöglichen, die genaue Gradation aller Farbtöne wiedergeben und anzeigen, ob die Grautöne neutral sind. Sie soll weiterhin die eventuelle Notwendigkeit zur Abschwächung einer der Farben angeben und/oder Hinweise zur Änderung der Filmvorlage vor der Herstellung der Druckplatte liefern.

Die Prüfung für den Mehrfarbendruck wird bisher mit Hilfe von Farbandrucken vorgenommen. Hierzu müssen alle auch beim tatsächlichen Mehrfarbendruck notwendigen Schritte durchgeführt werden. Ein solches Farbprüfverfahren ist kostspielig und zeitaufwendig. Man hat deshalb andere Farbprüfverfahren entwickelt, die dem Farbandruck in der Qualität gleichkommen sollen.

Für die Erstellung von druckverbindlichen Farbprüfbildern (Druckraster, Farbort ähnlich der Druckfarbe) haben sich bisher ausschließlich photochemisch und elektrophotographisch arbeitende Systeme durchgesetzt.

Daneben gibt es physikalische Methoden zur Bilderzeugung, wie zum Beispiel Ink Jet-, Thermotransfer-, Thermosublimations-Verfahren, die zwar zu guten Farbbildern führen können, aber durch die fehlende Druckrasterung nicht mit druckverbindlichen Farbprüfbildern vergleichbar sind.

Photochemisch arbeitende Farbprüfsysteme sind in einer Vielzahl von Ausführungen bekannt.
Die sogenannten Overlay-Systeme, wie beispielsweise in GB-A 1 143 679 oder US-A 4 489 153 beschrieben, besitzen jedoch den Nachteil, daß das zu prüfende Bild aus vier separaten Folien durch Übereinanderlegen der Teilbilder in den vier Grundfarben erzeugt wird und daß damit der Bildeindruck durch die Eigenfärbung der Folien stark verfälscht werden kann.

Die Weiterentwicklung auf dem Farbprüfgebiet führte dann zu einem Bildaufbau auf einem Schichtträger über verschiedene Laminierschritte. Die Erzeugung des endgültigen Farbbildes erfolgt dabei in unterschiedlicher Art und Weise. Bei den Schichttransferverfahren, wie beispielsweise in US-A 4 869 993 und EP-A 0 035 028, entsprechend US-A 4 260 673, beschrieben, werden nacheinander die einzelnen, unbelichteten Schichten über eine Adhäsivschicht auf einen Schichtträger übertragen, dort belichtet und entwickelt.

Im Falle der Bildtransfer-Systeme, wie beispielsweise in DE-A 19 12 864, entsprechend US-A 3 721 557, oder DE-A 38 13 722, entsprechend US-A 4 980 260, beschrieben, erfolgt die Belichtung und Entwicklung vor dem Laminierschritt, wonach dann die Teilbilder in den Grundfarben über eine Adhäsivschicht auf einem Schichtträger zusammengefügt werden.

Darüber hinaus sind Prozesse bekannt, bei denen ungefärbte lichtempfindliche Schichten auf einen Schichtträger laminiert, unter den entsprechenden Farbauszügen belichtet und gegebenenfalls entwickelt werden. Dabei kommt es in der Schichtoberfläche zu einer Differenzierung zwischen klebrigen und nichtklebrigen Schichtbereichen. Auf den klebrigen Schichtteilen wird ein Farbpulver fixiert, wodurch Teilbilder in den entsprechenden Grundfarben entstehen. Derartige Verfahren sind beispielsweise in US-A 4 356 253 oder EP-A 0 320 900 beschrieben.

Alle bekannten Laminierverfahren besitzen den entscheidenden Nachteil, daß trotz aller Nähe zu einem gedruckten Bild, der Bildeindruck durch die Gegenwart von Adhäsiv- bzw. Polymerschichten, in welche die Bildelemente der Teilbilder in den Grundfarben eingebettet sind, im Vergleich zum Druckbogen, bei welchem die einzelnen Farbpunkte direkt auf dem Bedruckstoff sitzen, gestört ist.

Zur Überwindung dieses Nachteiles wird beispielsweise in der EP-A 0 277 038 ein Verfahren beschrieben, bei dem die Adhäsiv- bzw. Polymerschichten in den Nichtbildstellen durch einen Entwicklungschritt entfernt werden. In den Bildstellen bleiben die Adhäsiv- bzw. Polymerschichten jedoch erhalten, was wiederum zu einer Verfälschung des Bildeindruckes führt.

Ein Verfahren, das ohne Adhäsivschichten arbeitet, wird in GB-A 2 213 950 beschrieben. Dabei wird eine photopolymerisierbare, eingefärbte Schicht bildmäßig belichtet und anschließend mit einem Bedruckstoff in Kontakt gebracht. Unter Ausnutzung des Klebrigkeitsunterschiedes werden unter Anwendung von Druck und Wärme die nicht ausbelichteten, klebrigen eingefärbten Schichtbestandteile auf den Bedruckstoff übertragen.

Dieses Verfahren hat den Nachteil, daß es auf Photopolymersysteme beschränkt ist, und zudem lichtempfindliche Schicht und eingefärbte Schicht zusammen vorliegen. Damit können keine Photoinitiatorsysteme eingesetzt werden, die eine ausreichende Absorption im sichtbaren Wellenlängenbereich aufweisen.

Die neuerdings propagierten, elektrophotographisch arbeitenden Farbprüfsysteme, wie beispielsweise in US-A 4 510 223 und EP-A 0 236 783 beschrieben, beseitigen zwar diesen Mangel, jedoch zu einem sehr hohen Geräte- und Prozeßaufwand und zu damit verbundenen hohen Kosten.

Aufgabe der vorliegenden Erfindung war es, ein Verfahren zur Herstellung eines Mehrfarben-Prüfbildes und ein hierfür geeignetes strahlungsempfindliches Aufzeichnungsmaterial anzugeben, das je nach Ausführungsform, zu einem positiv, negativ oder digital erzeugbaren, dem Druck entsprechenden Mehrfarben-Prüfbild auf einem Bildträger, wie Papier oder einem anderen geeigneten Substrat, führt, ohne daß der Bildeindruck durch irgendwelche dazwischenliegende Schichten oder gefärbte Photoinitiatoren verfälscht wird.

Die Aufgabe wird gelöst durch ein Verfahren zur Herstellung eines Mehrfarben-Prüfbildes, bei dem man ein strahlungsempfindliches Aufzeichnungsmaterial verwendet, bestehend aus einem temporären, flächigen Schichtträger, einer thermisch übertragbaren Schicht, die ein Farbmittel und ein Bindemittel enthält, das so ausgewählt ist, daß der Erweichungsbereich der Schicht bei 50 bis 150 °C liegt, und einer strahlungsempfindlichen Schicht, die einen Erweichungsbereich besitzt, der bei Temperaturen über 100 °C liegt, gekennzeichnet durch die Kombination der Verfahrensschritte
a) bildmäßiges Belichten des Aufzeichnungsmaterials in einer Grundfarbe,
b) Entwickeln der belichteten Schicht mit einer wäßrig-alkalischen Lösung unter Freilegen der thermisch übertragbaren Bildbereiche,
c) schichtseitiges Kontaktieren des Aufzeichnungsmaterials mit einem Bildträger und Übertragen der Bildbereiche auf den Bildträger unter Anwendung von Wärme und Druck, wodurch man ein Teilbild in der ersten Grundfarbe erzeugt,
und Wiederholen der vorstehenden Verfahrensschritte mindestens einmal mit einem strahlungsempfindlichen Aufzeichnungsmaterial, das ein Farbmittel in einer anderen Grundfarbe in der thermisch übertragbaren Schicht enthält.

In besonderer Ausführungsform wird das erzeugte Mehrfarben-Prüfbild als ganzes von dem Bildträger auf einen permanenten Bildträger unter Wärme und Druck übertragen, wodurch man ein seitenrichtiges Mehrfarben-Prüfbild erhält.

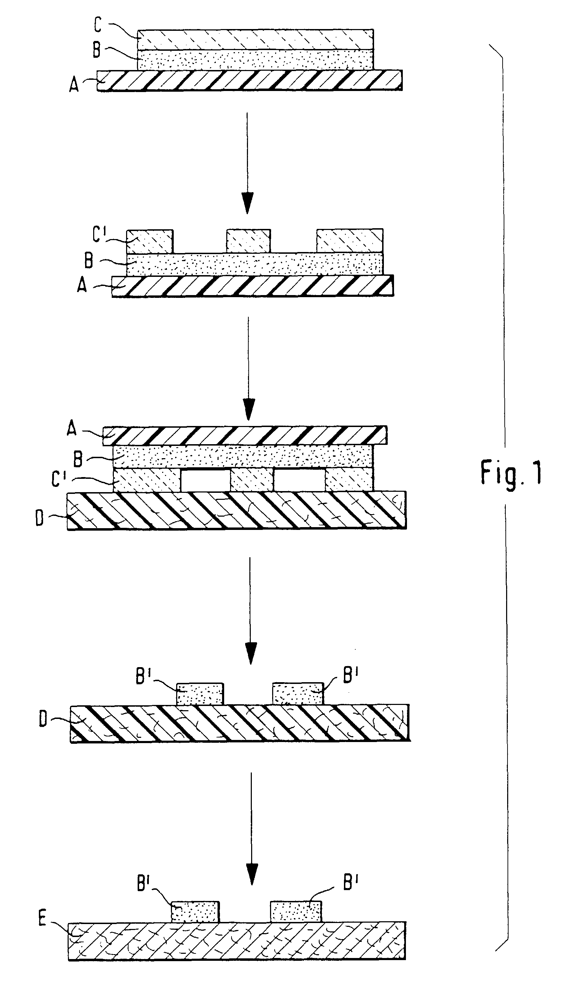

Das erfindungsgemäße Verfahren ist schematisch in der beigefügten Figur dargestellt. Unter A ist der temporäre, flächige Schichtträger angegeben. Position B weist die Farbmittel enthaltende, thermisch übertragbare Schicht aus und Position C gibt die strahlungsempfindliche Schicht wieder. Nach Belichten und Entwickeln sind die Bereiche von B freigelegt (B'), die dann auf den Bildträger D, zum Beispiel Papier oder eine Polyesterfolie, unter Wärme und Druck übertragen werden. Hierdurch wird auf D ein Teilbild der ersten Grundfarbe erzeugt.

Auf gleiche Art und Weise werden über dem Teilbild der ersten Grundfarbe, zum Beispiel Cyan, (B') nacheinander die Teilbilder der übrigen Farben ,zum Beispiel Magenta, Gelb und Schwarz, passergenau erstellt. Das so erstellte Farbprüfbild wird vorzugsweise als ganzes auf einen permanenten Bildträger E, zum Beispiel Papier, unter Wärme und Druck übertragen, wodurch ein zur Originalfarbseparation seitenrichtiges Bild erzeugt wird.

Der temporäre, flächige Schichtträger A besteht üblicherweise aus einer maßbeständigen und chemisch resistenten Polyesterfolie, insbesondere aus Polyethylenterephthalat, die normalerweise eine Dicke von 25 bis 250 µm, vorzugsweise etwa 25 bis 130 µm und insbesondere etwa 25 bis 75 µm aufweist. Ihre Oberfläche kann glatt oder rauh sein.
Zur Abstimmung der Wechselwirkung mit der Farbmittel enthaltenden, thermisch übertragbaren Schicht B kann die Oberfläche der Schichtträgerfolie A je nach der chemischen Natur von B haftvermittelnd bzw. haftvermindernd behandelt oder beschichtet sein.

Die Farbmittel enthaltende, thermisch übertragbare Farbschicht B besteht jeweils aus einer Polymer- und/oder Wachsmatrix und mindestens einem Farbstoff oder Farbpigment der Farben Cyan, Magenta, Gelb und Schwarz. Darüber hinaus kann diese Schicht UV-Absorber, Antistatikum, Lackadditive und Weichmacher enthalten.
Thermisch übertragbare Farbschichten sind aus der Literatur, zum Beispiel EP-A 0 163 145, bekannt. Die Farbprüfung durch lokal (Bildpunkt) begrenzte Erwärmung geschieht dabei durch "dye diffusion thermal transfer" oder durch einen Transfer der Farbschicht, wie zum Beispiel beim "thermal wax transfer".
Derartige Schichten sind prinzipiell auch für das erfindungsgemäße Farbprüfverfahren (Übertragung durch die Bildmaske C' bei ganzflächiger thermischer Behandlung) einsetzbar.
Die Polymermatrix der Schicht B kann aus Polymeren folgender Monomerkomponenten und deren Kombination gebildet werden:
Vinylacetal aus C₁-C₄ Aldehyden, Vinylester aus C₂-C₆ Carbonsäuren, Acrylsäure und deren Ester mit C₁-C₈ Alkoholen, Methacrylsäure und deren Ester mit C₁-C₈ Alkoholen, Vinylchlorid, Styrol, Acrylnitril, Acrylamid aus C₁-C₄ Aminen, Methacrylamid aus C₁-C₄ Aminen, Crotonsäure, Butadien, Ethylen, Propylen.

Als weitere matrixbildende Substanzen kommen Cellulosederivate, natürliche und künstliche Wachse als solche oder als Zusatzstoffe in Frage.

Die Bindemittel der Schicht B sind so ausgewählt, daß der Erweichungsbereich der thermisch übertragbaren Schicht zwischen etwa 50 bis 150 °C, vorzugsweise zwischen etwa 50 bis 100 °C und besonders bevorzugt zwischen etwa 50 und 90 °C liegt. Zur Erzielung bestimmter Eigenschaften können die oben angegebenen Komponenten der Schicht zugegeben werden.

Als Farbmittel enthält die Schicht B mindestens einen Farbstoff, vorzugsweise mindestens ein Farbpigment, welches homogen in dem Bindemittel dispergiert ist. Zur Einstellung bestimmter Farbnuancen können Farbstoffe bzw. Farbpigmente verschiedener Farbtönungen miteinander kombiniert werden. Die durchschnittliche Teilchengröße der eingesetzten Farbpigmente beträgt maximal etwa 1 µm.

Als strahlungsempfindliche Schicht C sind grundsätzlich alle Schichten geeignet, die nach dem Bestrahlen (Belichten), gegebenenfalls mit einer nachfolgenden Entwicklung und/oder Fixierung eine bildmäßig differenzierte Fläche liefern, die einen Erweichungsbereich besitzen, der bei Temperaturen über 100 °C, vorzugsweise über 150 °C liegt.
Neben den auf vielen Gebieten verwendeten Silberhalogenid enthaltenden Schichten sind auch verschiedene andere bekannt: Die Chromate und Dichromate enthaltenden Kolloidschichten, die ungesättigte Verbindungen enthaltenden Schichten, in denen diese Verbindungen beim Belichten isomerisieren, sich umlagern, cyclisieren oder vernetzt werden, die photopolymerisierbare Verbindungen enthaltenden Schichten, in denen Monomere oder Präpolymere gegebenenfalls mittels eines Initiators beim Belichten polymerisieren, und die o-Diazochinone, wie Naphthochinondiazide, p-Diazochinone oder Diazoniumsalz-Kondensate enthaltende Schichten. Außer den lichtempfindlichen Substanzen können diese Schichten auch noch andere Bestandteile, wie zum Beispiel Bindemittel, Farbstoffe oder Weichmacher enthalten.

Insbesondere können die folgenden strahlungs- bzw. lichtempfindlichen Massen oder Verbindungen als Schicht C in den erfindungsgemäßen Aufzeichnungsmaterialien eingesetzt werden:
positiv-arbeitende, o-Chinondiazide, insbesondere o-Naphthochinondiazide, wie 1,2-Naphthochinon-(2)-diazid-4 oder 5-sulfonsäureester oder -amide, die nieder- oder höhermolekular sein können, als lichtempfindliche Verbindung enthaltende Reproduktionsschichten, die beispielsweise in DE-C 23 31 377, entsprechend US-A 3 969 118, beschrieben werden;
positiv-arbeitende Schichten nach DE-A 26 10 842, entsprechend US-A 4 101 323, oder DE-A 29 28 636, entsprechend US-A 4 311 782,die eine bei Bestrahlung säureabspaltende Verbindung, eine monomere oder polymere Verbindung, die mindestens eine durch Säure abspaltbare C-O-C-Gruppe aufweist, zum Beispiel eine Orthocarbonsäureestergruppe oder eine Carbonsäureamidacetalgruppe und gegebenenfalls ein Bindemittel enthalten;
negativ-arbeitende Schichten aus photopolymerisierbaren Monomeren, Photoinitiatoren, Bindemitteln und gegebenenfalls weiteren Zusätzen; als Monomere werden dabei beispielsweise Acryl- und Methacrylsäureester oder Umsetzungsprodukte von Diisocyanaten mit Partialestern mehrwertiger Alkohole eingesetzt, wie es beispielsweise in DE-A 23 61 041, entsprechend US-A 4 019 972, beschrieben wird;
negativ-arbeitende Schichten gemäß der DE-A 30 36 077, entsprechend US-A 4 387 151, die als lichtempfindliche Verbindung ein Diazoniumsalz-Polykondensationsprodukt oder eine organische Azidoverbindung und als Bindemittel ein hochmolekulares Polymeres mit seitenständigen Alkenylsulfonyl- oder Cycloalkenylsulfonylurethan-Gruppen enthalten;
negativ-arbeitende Reproduktionsschichten mit Kondensationsprodukten aus aromatischen Diazoniumsalzen und Verbindungen mit aktiven Carbonylgruppen, bevorzugt Kondensationsprodukte aus Diphenylamindiazoniumsalzen und Formaldehyd, die beispielsweise in US-A 2 679 498, und 3 050 502 beschrieben werden;
negativ-arbeitende, Mischkondensationsprodukte aromatischer Diazoniumverbindungen enthaltende Reproduktionsschichten, beispielsweise nach der DE-C 20 65 732, entsprechend US-A 3 867 147, die Produkte mit mindestens je einer Einheit aus a) einer kondensationsfähigen aromatischen Diazoniumsalzverbindung und b) einer kondensationsfähigen Verbindung, wie einem Phenolether oder einem aromatischen Thioether, verbunden durch ein zweibindiges, von einer kondensationsfähighen Carbonylverbindung abgeleitetes Zwischenglied, wie einer Methylengruppe aufweisen.

Die genannten photochemisch arbeitenden strahlungs- bzw. lichtempfindlichen Schichten eignen sich in erster Linie für die Herstellung von Mehrfarben-Prüfbildern zur analogen Bebilderung.

Für die Bebilderung mit digital gesteuerten Belichtungsquellen, zum Beispiel Laserstrahlung, sind wesentlich höhere Lichtempfindlichkeiten der Schicht C erforderlich. Deshalb besteht die Schicht C in diesem Fall aus einer lichtempfindlichen Schichtzusammensetzung von Silberhalogeniden oder, bevorzugt, aus hochlichtempfindlichen Photopolymerformulierungen wie sie in DE-A 37 10 281, entsprechend US-A 4 983 498, oder DE-A 38 32 032 beschrieben sind.

Die Strahlung kann aus dem gesamten elektromagnetischen Spektrum mit Einschluß von sichtbarem Licht, UV-oder IR-Strahlung, und Elektronenstrahlung ausgewählt werden. Eine bevorzugte Strahlung liegt im UV-Bereich.

Die Herstellung des erfindungsgemäß verwendeten strahlungsempfindlichen Aufzeichnungsmaterials erfolgt nach bekannten Beschichtungsmethoden. Die eingefärbte, thermisch übertragbare Schicht B wird in einer Schichtdicke von 0,5 bis 10 µm, bevorzugt 1 bis 5 µm, insbesondere von 1 bis 3 µm, durch Extrusion oder Beschichtung aus einer Lösung und Trocknen auf den temporären Schichtträger aufgebracht. Um Interferenzen mit der anschließend aufzubringenden strahlungsempfindlichen Schicht C zu vermeiden bzw. zu minimieren, erfolgt die Beschichtung entsprechend der Natur des verwendeten Bindemittels entweder aus stark polaren Lösemitteln, wie Wasser, Alkoholen etc. oder aus relativ unpolaren Lösemitteln, wie Toluol, Xylol, Cyclohexan oder Pentan usw.
Auf die Schicht B wird anschließend aus einer Lösung die strahlungsempfindliche Schicht C in einer Schichtdicke von 0,5 bis 10 µm, bevorzugt von 1 bis 5 µm, aufgebracht und getrocknet. Bevorzugt verwendete Lösemittel dafür sind Glykolether, Ketone und Ester. Eine weitere Methode zum Aufbringen der strahlungsempfindlichen Schicht C auf die thermisch übertragbare Schicht B besteht darin, die Schichten unter geeigneten Bedingungen durch Laminieren miteinander zu verbinden. Die strahlungsempfindliche Schicht wird dabei separat auf einen temporären Zwischenträger aus Lösung geschichtet. Der Zwischenträger besteht beispielsweise aus einer Polyesterfolie, etwa einer Polyethylenterephthalatfolie, deren Oberfläche gegebenenfalls in geeigneter Weise dehäsiv vorbehandelt worden ist.

Neben den für das Verfahren notwendigen Schichten B und C kann das erfindungsgemäß verwendete Aufzeichngsmaterial noch weitere Schichten zur Steuerung der Verarbeitungsschritte besitzen. So kann zwischen dem temporären Schichtträger A und der thermisch übertragbaren Schicht B eine Trennschicht, zum Beispiel aus Polyvinylalkohol, angeordnet sein, die die spätere übertragung der farbgebenden Bildbereiche erleichtert und wobei die Trennschicht auf der Schichtoberfläche A zurückbleibt.

Gegebenenfalls kann sich zwischen der Farbmittel enthaltenden, thermisch übertragbaren Schicht B und der strahlungsempfindlichen Schicht C eine Barriereschicht befinden, die Vermischungen der Schichten bzw. Migrationen von Substanzen aus der einen in die andere Schicht verhindert.

Bedingung für eine solche Barriereschicht ist, daß sie beim Entwicklungsvorgang von C vollständig aus den späteren Bildbereichen (freigelegte Bereiche von B) entfernt wird.
Bei der Ausgestaltung der strahlungsempfindlichen Schicht C als Photopolymerschicht ist das Aufbringen einer Sauerstoffbarriere unabdingbar. Die Sauerstoffbarriere kann dabei aus einer Deckfolie aus Polyethylen oder Polyester bestehen oder durch eine Deckschicht auf Polyvinylalkoholbasis gebildet werden.

Wie schon erwähnt, umfaßt das erfindungsgemäße Verfahren zur Herstellung von Mehrfarben-Prüfbildern in den vier Grundfarben aus den oben beschriebenen Aufzeichnungsmaterialien folgende Verfahrensschritte:
1. bildmäßiges Belichten der Farbfolie in der Grundfarbe 1,
2. Entwickeln der belichteten Schicht C, wobei die zum zurückbleibenden Bild der Schicht C (= C') komplementären Bereiche von B freigelegt werden.
3. Kontaktieren der Schichtseite des derart vorbereiteten Aufzeichnungsmaterials mit dem Bildträger D und Übertragen der freigelegten Bereiche von B auf den Bildträger D unter Einwirkung von Wärme und Druck, wobei die Bereiche C' sowie die hierunterliegenden Bereiche B auf dem temporären Schichtträger A zurückbleiben,
4. Wiederholen der Schritte 1 bis 3 mit einer Farbfolie in der Grundfarbe 2,
5. Wiederholen der Schritte 1 bis 3 mit einer Farbfolie in der Grundfarbe 3 und
6. Wiederholen der Schritte 1 bis 3 mit einer Farbfolie in der Grundfarbe 4.

Im Falle der Analogbelichtung von C durch Filmmasken entsteht so auf dem Bildträger D ein zu dem Bild der Filmmaske seitenverkehrtes Bild.

Eine besondere Ausführungsform des Verfahrens verwendet deshalb Bildträger D als Zwischenbildträger, auf welchem gemäß der Schritte 1 bis 6 das seitenverkehrte Bild aufgebaut wird. In einem Zusatzschritt 7 wird dann das gesamte Farbprüfbild auf den permanenten Bildträger E unter Einwirkung von Wärme und Druck übertragen, wodurch man auf E das zu den ursprünglich eingesetzten Filmmasken seitenrichtige Farbprüfbild erhält.

Das erfindungsgemäße Verfahren dient zur Herstellung von Farbprüfbildern aus in Form von Negativfilmen, Positivfilmen oder digital vorliegenden Farbseparationen. Für die Bebilderung mit Negativ-Filmvorlagen basiert die Formulierung der strahlungsempfindlichen Schicht C auf Chinondiazidverbindungen als photoreaktiver Komponente und phenolhaltigen Bindemitteln, zum Beispiel Novolaken, wie sie aus positiv-arbeitenden lichtempfindlichen Materialien her bekannt sind. Zur Erstellung eines Mehrfarben-Prüfbildes, ausgehend von einer Positivfarbseparation besteht die strahlungsempfindliche Schicht C aus photovernetzenden Systemen, wie zum Beispiel Diazoniumsalz-Polykondensaten, polymerisationsfähigen Monomeren in Verbindung mit Photoinitiatoren und/oder Sensibilisatoren und polymeren Bindemitteln.
Für die Herstellung eines Prüfbildes aus digitalen Datenbeständen über eine direkte Laserbebilderung mit Laserlicht einer Wellenlänge im Bereich von 350 bis 850 nm basiert die strahlungsempfindliche Schicht C auf der Silberhalogenidchemie bzw. auf dem Photopolymersystem. Im Falle der bevorzugten Photopolymerschichten ist die verwendbare Laserlichtquelle auf Wellenlängen unter 650 nm eingeschränkt.
Die bildmäßige Übertragung der Farbschicht B durch die Bildmaske C' auf den Träger D erfolgt unter Anwendung von Wärme und Druck. Je nach Art der Schicht B wird zur Bildübertragung eine Temperatur zwischen 50 und 150 °C, bevorzugt zwischen 50 und 100 °C angewendet. Dabei werden die Materialien mit einem Druck von 0,1 bis 1,0 kp/cm², bevorzugt von 0,2 bis 0,7 kp/cm², beaufschlagt.
Das erfindungsgemäße Verfahren zur Herstellung eines Mehrfarben-Prüfbildes hat den Vorteil, daß es je nach Ausführungsform zu einem positiv, negativ oder digital erzeugbaren Prüfbild führt, ohne daß der Bildeindruck durch dazwischenliegende Schichten verfälscht wird.

In den nachfolgenden Beispielen werden die Verfahrensabläufe und die hierfür notwendigen strahlungsempfindlichen Aufzeichnungsmaterialien exemplarisch dargestellt, ohne die Erfindung hierauf zu beschränken.

### BEISPIEL 1:

Die Farbmittel enthaltenden, thermisch übertragbaren Schichten werden wie folgt hergestellt. (Die Angaben beziehen sich auf Gewichtsprozente, C.I. gleich Color Index).

| | Cyan | Gelb | Magenta | Schwarz |
|---|---|---|---|---|
| Ethylen-Vinylacetat Copolymer (Vinylacetat gehalt 23 bis 30 %, Tropfpunkt 80 °C) | 9 | 9 | 9 | 9 |
| Blau Pigment,C.I. 74160 | 1 | - | - | - |
| Gelb Pigment,C.I. 21100 | - | 1 | - | - |
| Magenta Pigment, C.I. 12485 | - | - | 1 | - |
| Black Pigment, Printex 25 | - | - | - | 1 |
| Toluol | 90 | 90 | 90 | 90 |

Die Dispersionen werden 50 Minuten lang bei 40 °C in einer Kugelmühle bei 500 U/min vermahlen.
Die erhaltenen Dispersionen werden dann mit Hilfe einer Rakel auf eine 50 µm dicke Polyethylenterephthalatfolie als temporären Schichtträger aufgebracht und bei 100 °C 3 Minuten lang getrocknet. Das Schichtgewicht liegt bei 2,6 g/m².
Auf diese eingefärbten Schichten wird dann jeweils die strahlungsempfindliche Schicht der folgenden Zusammensetzung aufgebracht (GT gleich Gewichtsteil).

| | |
|---|---|
| 1,5 GT | Ester aus 3 Mol 1,2-Naphthochinon-(2)-diazid-4-sulfonsäurechlorid und 1 Mol 2,3,4-Trihydroxybenzophenon, |
| 6,9 GT | m-Cresol-Formaldehyd Novolak, MW = 6 000, |
| 45,8 GT | Propylenglykolmonomethylether, |
| 45,8 GT | Tetrahydrofuran |

Die Lösung wird auf die eingefärbten Schichten aufgeschleudert und 2 Minuten lang bei 100 °C getrocknet. Das Trockengewicht der lichtempfindlichen Schicht beträgt 2,0 g/m².
Die Aufzeichnungsmaterialien mit den vier Grundfarben werden dann mit einer Belichtungszeit von 30 Sekunden unter Verwendung von entsprechenden Farbauszugsmasken mit einer 5 kW Gallium dotierten Quecksilberhochdrucklampe belichtet und einzeln in einer wäßrig-alkalischen Entwicklerlösung entwickelt.
Anschließend wird ein erstes, Cyan-eingefärbtes Farbprüfbild, auf einen Bildträger in Form einer Bildempfangsfolie gelegt, so daß die übertragbaren, Farbmittel enthaltenden Schichtbestandteile in Kontakt zur Bildträgeroberfläche stehen. Der Verbund wird dann durch Führen durch ein auf 70 °C erhitztes Rollenpaar eines Laminators unter einem Druck von 0,6 kp/cm² bei einer Geschwindigkeit von 60 cm/min hergestellt.
Nach dem Abziehen des temporären Schichtträgers erhält man eine naturgetreue, seitenverkehrte Abbildung des Original Cyan-Farbauszuges. Man wiederholt den Laminierschritt mit den restlichen Grundfarben und Schwarz, wobei die Bildpositionen aufeinander abgestimmt werden müssen und erhält so ein Mehrfarben-Prüfbild.

In einem zusätzlichen Laminierschritt wird das Mehrfarben-Prüfbild als ganzes auf einen geeigneten permanenten Bildträger aus beschichtetem Papier übertragen, wodurch ein zur Originalfarbseparation seitenrichtiges Mehrfarben-Prüfbild erzeugt wird.

### BEISPIELE 2 bis 5:

Man verfährt wie in Beispiel 1 beschrieben mit der Änderung, daß die Farbmittel enthaltende, thermisch übertragbare Schicht Verbindungen gemäß Tabelle 1 enthält und daß die Laminierung bei den jeweils angegebenen Temperaturen erfolgt.

**TABELLE 1**

| | Bindemittel der thermisch übertragbaren Schicht | Laminiertemperatur | Bemerkung |
|---|---|---|---|
| 2 | Fettsäurealkohol (Smp. 48 - 50 °C) | 60 °C | |
| 3 | Fettsäureester (Smp. 45 - 47 °C) | 60 °C | |
| 4 | Copolymer aus Styrol-Butadien (ca. 80 % Styrol, 20 % Butadien) | 120 °C | lichtempfindliche Schicht wird mit übertragen |
| 5 | Polyvinylacetat (MW = 110 000) | 80 °C | Ausrisse in der Farbschicht |

### BEISPIEL 6:

Man verfährt wie in Beispiel 1 beschrieben mit der Änderung, daß die strahlungsempfindliche Schicht folgende Zusammensetzung hat:

| | |
|---|---|
| 5,9 GT | Tetraethylenglykoldiacrylat, |
| 16,9 GT | einer 34,4 %igen Lösung eines Copolymers aus Methylmethacrylat und Methacrylsäure mit einer Säurezahl von 190 in Butanon, |
| 0,8 GT | Samaronmarineblau HR, HOECHST AG, |
| 0,6 GT | Dibenzalaceton |
| 0,6 GT | 9-Phenylacridin |
| 76,8 GT | Methylglykol. |

Nach Auftragen einer Deckschicht als Sauerstoffbarriere aus Polyvinylalkohol (12 % Restacetylgruppen, K-Wert 4, Schichtdicke 2 g/m²) werden die Aufzeichnungsmaterialien 30 sec lang unter Verwendung von entsprechenden Farbauszugsmasken mit einer 5 kW Gallium dotierten Quecksilberhochdrucklampe belichtet und danach mit einer wäßrig-alkalischen Lösung durch Entschichten entwickelt.

### BEISPIEL 7:

Man verfährt wie in Beispiel 1 beschrieben mit der Änderung, daß die strahlungsempfindliche Schicht folgende Zusammensetzung hat:

| | |
|---|---|
| 2,9 GT | einer 34,8 %igen Lösung eines Terpolymerisats aus Styrol, n-Hexylmethacrylat und Methacrylsäure (10:60:30) mit einer Säurezahl von 190 in Butanon, |
| 4,5 GT | einer 31 %igen Lösung des Umsetzungsproduktes von Triethanolamin mit 3 Mol Isocyanatoethylmethacrylat in Butanon, |
| 0,04 GT | Eosin, alkohollöslich, (C.I. 45 386), |
| 0,03 GT | 2,4-Bis-trichlormethyl-6-(4-styryl-phenyl)-s-triazin, |
| 0,06 GT | 9-Phenylacridin, |
| 0,2 GT | 2,5-Bis-(4-diethylamino-phenyl)-1,3,4-oxdiazol, |
| 0,2 GT | 4-Dimethylamino-4'-methoxy-dibenzalaceton in |
| 20 GT | Propylenglykolmonomethylether. |

Nach Auftragen einer Deckschicht aus Polyvinylalkohol (12 % Restacetylgruppen, K-Wert 4, Schichtdicke 2 g/m²) wird das Aufzeichnungsmaterial unter einem 3 mm starken Kantenfilter der Firma Schott, das Wellenlängen unter 455 nm absorbiert, 40 sec lang mit einer 100 W starken Glühlampe belichtet und danach eine Minute bei 100 °C erwärmt. Anschließend wird die strahlungsempfindliche Schicht mit einer wäßrig-alkalischen Lösung durch Entschichten entwickelt.

Nach dem Laminieren erhält man ein naturgetreues, seitenverkehrtes Abbild der Originalfarbseparation.

### Beispiel 8:

Man verfährt wie in Beispiel 1 beschrieben mit der Änderung, daß die strahlungsempfindliche Schicht folgende Zusammensetzung hat:

| | |
|---|---|
| 8,9 GT | einer 34,8 %igen Lösung eines Terpolymerisats aus Styrol, n-Hexylmethacrylat und Methacrylsäure (10:60:30) mit einer Säurezahl von 190 in Butanon, |
| 13,6 GT | einer 31 %igen Lösung des Umsetzungsproduktes von Triethanolamin mit 3 Mol Isocyanatoethylmethacrylat in Butanon, |
| 0,4 GT | Eosin, alkohollöslich, (C.I. 45 386), |
| 0,03 GT | 2,4-Bis-trichlormethyl-6-(4-styryl-phenyl)-s-triazin, |
| 0,04 GT | Bis(cyclopentadienyl)-bis-(pentafluorphenyl)-titan, |
| 77,03 GT | Propylenglykolmonomethylether. |

Nach Auftragen einer Deckschicht aus Polyvinylalkohol (12 % Restacetylgruppen, K-Wert 4, Schichtdicke 2 g/m²) wird das Aufzeichnungsmaterial unter einem 3 mm starken Kantenfilter der Firma Schott, das Wellenlängen unter 455 nm absorbiert, 40 sec lang mit einer 100 W starken Glühlampe belichtet und danach eine Minute bei 100 °C erwärmt. Anschließend wird die strahlungsempfindliche Schicht mit einer wäßrig-alkalischen Lösung entschichtet.

### BEISPIEL 9:

Man verfährt wie in Beispiel 1 beschrieben mit der Änderung, daß die strahlungsempfindliche Schicht folgende Zusammensetzung hat:

| | |
|---|---|
| 8,9 GT | einer 34,8 %igen Lösung eines Terpolymerisates aus Styrol, n-Hexylmethacrylat und Methacrylsäure (10:60:30) mit einer Säurezahl von 190 in Butanon, |
| 13,6 GT | einer 31 %igen Lösung des Umsetzungsproduktes von Triethanolamin mit 3 Mol Isocyanatoethylmethacrylat in Butanon, |
| 0,4 GT | Eosin, alkohol-löslich (C.I. 45 386), |
| 0,03 | 2,4-Bis-trichlormethyl-6-(4-styryl-phenyl)-s-triazin, |
| 0,04 GT | Bis(cyclopentadienyl)-bis[2,6-difluor-3-(pyrr-1-yl)phenyl]-titan, |
| 77,03 GT | Propylenglykolmonomethylether |

Nach Auftragen einer Deckschicht aus Polyvinylalkohol (12 % Restacetylgrupen, K-Wert 4, Schichtdicke 2 g/m²) wird das Aufzeichnungsmaterial unter einem 3 mm starken Kantenfilter der Firma Schott, das Wellenlängen unter 455 nm absorbiert, 40 sec lang mit einer 100 W starken Glühlampe belichtet und danach eine Minute bei 100 °C erwärmt. Anschließend wird die strahlungsempfindliche Schicht mit einer wäßrig- alkalischen Lösung entwickelt bzw. entschichtet.

Nach dem Laminieren erhält man ein originalgetreues, seitenverkehrtes Mehrfarben-Prüfbild.

### BEISPIEL 10:

Man verfährt wie in Beispiel 1 beschrieben mit der Änderung, daß die strahlungsempfindliche Schicht folgende Zusammensetzung hat:

| | |
|---|---|
| 62 GT | eines Polymeren mit einer Säurezahl von 40, hergestellt durch Umsetzung eines Polyvinylbutyrals mit einem Molekulargewicht von 70.000 bis 80.000, das 71 % Vinylbutyral-, 2 % Vinylacetat- und 27 % Vinylalkoholeinheiten enthält, mit Maleinsäureanhydrid, |
| 21 GT | eines Diazoniumsalz-Polykondensations produktes aus 1 Mol 3-Methoxy-diphenylamin-4-diazoniumsulfat und 1 Mol 4,4'-Bis-methoxymethyldiphenylether in 85 %-iger Phosphorsäure und isoliert als Mesitylensulfonat, |
| 2,5 GT | Phosphorsäure (85%), |
| 0,6 GT | Phenylazodiphenylamin in |
| 2570 GT | Ethylenglykolmonomethylether und |
| 780 GT | Tetrahydrofuran |

Die so erhaltene Kopierschicht, die nach dem Trocknen ein Schichtgewicht von 1,5 g/m² aufweist, wird unter einer Negativ-Vorlage 30 sec lang mit einer Metallhalogenid-Lampe von 5 kW Leistung belichtet und mit einer wäßrig-alkalischen Lösung entwickelt.
Nach dem Laminieren wird der temporäre Schichtträger abgezogen, wonach ein scharfes, naturgetreues, seitenverkehrtes Abbild der Originalfarbseparation erhalten wird.

## Patentansprüche

1. Verfahren zur Herstellung eines Mehrfarben-Prüfbildes, bei dem man ein strahlungsempfindliches Aufzeichnungsmaterial verwendet, bestehend aus einem temporären, flächigen Schichtträger, einer thermisch übertragbaren Schicht, die ein Farbmittel und ein Bindemittel enthält, das so ausgewählt ist, daß der Erweichungsbereich der Schicht bei 50 bis 150 °C liegt, und einer strahlungsempfindlichen Schicht, die einen Erweichungsbereich besitzt, der bei Temperaturen über 100 °C liegt, gekennzeichnet durch die Kombination der Verfahrensschritte
a) bildmäßiges Belichten des Aufzeichnungsmaterials in einer Grundfarbe,
b) Entwickeln der belichteten Schicht mit einer wäßrig-alkalischen Lösung unter Freilegen der thermisch übertragbaren Bildbereiche,
c) schichtseitiges Kontaktieren des Aufzeichnungsmaterials mit einem Bildträger und Übertragen der Bildbereiche auf den Bildträger unter Anwendung von Wärme und Druck, wodurch man ein Teilbild in der ersten Grundfarbe erzeugt,
und Wiederholen der vorstehenden Verfahrensschritte mindestens einmal mit einem strahlungsempfindlichen Aufzeichnungsmaterial, das ein Farbmittel in einer anderen Grundfarbe in der thermisch übertragbaren Schicht enthält.

2. Verfahren nach Anspruch 1, dadurch gekennzeichnet, daß man das erzeugte Mehrfarben-Prüfbild als ganzes auf einen permanenten Bildträger unter Anwendung von Wärme und Druck überträgt.

3. Verfahren nach Anspruch 1, dadurch gekennzeichnet, daß zur Übertragung der übertragbaren Bildbereiche eine Temperatur im Bereich zwischen 50 und 150 °C und ein Druck im Bereich von 0,1 bis 1,0 kp/cm² angewendet werden.

4. Verfahren nach Anspruch 1, dadurch gekennzeichnet, daß die Farbmittel enthaltende thermisch übertragbare Schicht einen Erweichungsbereich zwischen 50 und 100 °C besitzt.

5. Verfahren nach Anspruch 1, dadurch gekennzeichnet, daß die strahlungsempfindliche Schicht nach dem Bestrahlen und gegebenenfalls Entwickeln eine bildmäßig differenzierte Fläche liefert, die einen Erweichungsbereich besitzt, der über 150 °C liegt.

## Claims

1. Process for the production of a multi-colour proof, in which a radiation-sensitive recording material is used consisting of a temporary, flat layer support, a thermally transferable layer, which contains a dye. and a binder which is selected such that the softening range of the layer is from 50 to 150°C, and a radiation-sensitive layer, which has a softening range which is at temperatures of above 100°C, characterised by the combination of the process stages
a) image-wise exposure of the recording material in a primary colour,
b) development of the exposed layer with an aqueous-alkaline solution to expose the thermally transferable image areas
c) bringing the layer side of the recording material into contact with an image support and transferring the image areas onto the image support using heat and pressure, so producing a partial image in the first primary colour,
and repetition of the above process stages at least once with a radiation-sensitive recording material, which contains in the thermally transferable layer a colourant of a different primary colour.

2. Process according to claim 1, characterised in that the multi-colour proof is transferred in its entirety onto a permanent image support using heat and pressure.

3. Process according to claim 1, characterised in that the transferable image areas are transferred using a temperature in the range between 50 and 150°C and a pressure in the range from 0.1 to 1.0 kp/cm².

4. Process according to claim 1, characterised in that the thermally transferable layer containing the colourants has a softening range between 50 and 100°C.

5. Process according to claim 1, characterised in that, once the radiation-sensitive layer has been exposed to radiation and optionally developed, it provides a surface differentiated in accordance with the image, which surface has a softening range which is above 150°C.

## Revendications

1. Procédé de production d'une épreuve polychrome dans lequel on utilise un matériau d'enregistrement sensible aux rayonnements consistant en un support de couches plan temporaires, en une couche thermiquement transférable qui contient un agent colorant et un liant qui est choisi de manière que le domaine de ramollissement de la couche soit situé entre 50 et 150°C, et en une couche sensible aux rayonnements qui possède un domaine de ramollissement qui est situé à des températures supérieures à 100°C, caractérisé par la combinaison des étapes de procédé suivantes
a) exposition selon une image du matériau d'enregistrement dans une couleur primaire,
b) développement de la couche exposée avec une solution aqueuse alcaline, avec mise à découvert des domaines d'image thermiquement transférables,
c) mise en contact du côté couche du matériau d'enregistrement avec un support d'image et transfert des domaines d'image sur le support d'image par utilisation de chaleur et de pression, de sorte que l'on forme une image partielle dans la première couleur primaire,
et répétition des étapes de procédé précédentes au moins une fois avec un matériau d'enregistrement sensible aux rayonnements qui contient un agent colorant dans une autre couleur primaire dans la couche thermiquement transférable.

2. Procédé selon la revendication 1, caractérisé en ce que l'on transfère en totalité l'épreuve polychrome produite sur un support d'image permanent en utilisant la chaleur et la pression.

3. Procédé selon la revendication 1, caractérisé en ce que, pour le transfert des domaines d'image transférables, on utilise une température dans le domaine de 50 à 150°C et une pression dans le domaine de 0,1 à 1,0 kp/cm².

4. Procédé selon la revendication 1, caractérisé en ce que la couche thermiquement transférable contenant des agents colorants possède un domaine de ramollissement compris entre 50 et 100°C.

5. Procédé selon la revendication 1, caractérisé en ce que la couche sensible aux rayonnements donne, après l'irradiation et éventuellement le développement, une surface différenciée selon une image qui possède un domaine de ramollissement qui est situé au-delà de 150°C.
